# EUROPÄISCHE PATENTSCHRIFT

(11) **EP 2 659 023 B1**
(45) Veröffentlichungstag und Bekanntmachung des Hinweises auf die Patenterteilung: **08.03.2017**
(21) Anmeldenummer: 11801983.5
(22) Anmeldetag: 15.12.2011
(51) Int. Cl.: C23C 14/50, C21D 9/00, F27D 5/00, B05C 13/02, C23C 16/458

(54) **HALTERUNG FÜR BOHRKOPFBESCHICHTUNG**
HOLDER FOR BORING HEAD COATING
SUPPORT POUR L'APPLICATION DE REVÊTEMENTS SUR DES POINTES DE FORETS

(30) Priorität: 28.12.2010 DE 102010056157
(43) Veröffentlichungstag der Anmeldung: 06.11.2013
(73) Patentinhaber: Oerlikon Surface Solutions AG, Pfäffikon, 8808 Pfäffikon (CH)
(72) Erfinder: HEINE-KEMPKENS, Claus, CH-7304 Maienfeld (CH); HOCHSCHWARZER, Martin, A-6890 Lustenau (AT); DIETZ, Michael, FL-9497 Triesenberg (LI)
(74) Vertreter: Kempkens, Anke
(86) Internationale Anmeldenummer: PCT/EP2011/006321
(87) Internationale Veröffentlichungsnummer: WO 2012/089306

(56) Entgegenhaltungen:
- CN-C- 100 529 171
- JP-A- 4 052 274

## Beschreibung

Die vorliegende Erfindung bezieht sich auf die Beschichtung von Bohrern und auf die dazu verwendbaren Halter.

Zur Verbesserung des Verschleissverhaltens von Bohrern ist bekannt, deren Spitze und Spannuten mit Hartstoffschichten wie zum Beispiel Titannitrid oder Aluminiumchromnitrid zu beschichten. Üblicherweise werden zum Aufbringen der Schichten PVD-Verfahren, wie zum Beispiel Bogenverdampfen, Elektronenstrahlverdampfen oder Zerstäuben, im Batchverfahren verwendet. Batchverfahren heisst dabei, dass Halter mit den zu beschichtenden Bohrern bestückt werden und diese Halter auf einer Art Drehtisch angeordnet sind, welcher durch Rotation dafür sorgt, dass die Bohrer mehrmals an der Beschichtungsquelle vorbeigeführt werden. Dabei wird versucht, den Halter so zu konstruieren, dass lediglich die Bohrerspitze und der Bereich direkt hinter der Spitze beschichtet werden.

Aus der DE 600 02 579 T2 ist es bekannt, eine Halterung einzusetzen, die zumindest eine perforierte Aussenwand umfasst, die mit einer Anordnung von Öffnungen versehen ist, in die Bohrer eingesetzt werden können. Innerhalb des hohlen Innenraums der Halterung ist eine zur Aussenwand parallele Stützwand mit entsprechenden Öffnungen vorgesehen, so dass die Bohrer mit ihren Schäften im Wesentlichen parallel angeordnet werden können. Ausserdem ist ein von der Stützwand nach innen beabstandetes Anschlagmittel innerhalb des hohlen Innenraums der Halterung vorgesehen, um dafür zu sorgen, dass die Bohrer im Wesentlichen im gleichen Ausmass aus der Aussenwand herausragen. Die Halterung ist dabei als hohle Halterung ausgebildet, um denjenigen Teil eines Bohrers innerhalb der Aussenwand von der äusseren Umgebung abzuschirmen, aber der Atmosphäre im Innenraum der Halterung auszusetzen.

Die Halterung wie in der DE 600 02 579 T2 offenbart hat allerdings den Nachteil, dass sie in Polygonform ausgebildet ist und die Bohrer bei der Beschichtung aus einer Aussenfläche der polygonalen Form herausragen. Wenn daher die Bohrerspitzen an der Beschichtungsquelle vorbeirotieren, haben diejenigen Bohrer, welche nahe den Ecken des Polygons angeordnet sind, einen geringeren minimalen Abstand zur Beschichtungsquelle als diejenigen Bohrer, welche im Zentrum der Polygonfläche liegen. Hierdurch kommt es zu einer ungewünschten unterschiedlichen Dicke der Beschichtung der Bohrer. Es kommt hinzu, dass diejenigen Bohrer, welche nahe der Ecken des Polygons angeordnet sind, dann, wenn sie den geringsten Abstand zur Beschichtungsquelle haben, nicht senkrecht auf der Oberfläche der Beschichtungsquelle stehen. Es wird daher eine Seite der Spannut abgeschattet sein, während die andere Seite der Spannut der Quelle direkter ausgesetzt ist. Da zu diesem Zeitpunkt am meisten Material auf der Bohreroberfläche abgelegt wird kommt es zu einer unerwünscht unsymmetrischen Beschichtung dieser Bohrer. Ein weiterer Nachteil ist, dass dadurch, dass es sich um eine hohle Halterung handeln muss, die Flexibilität an Beschichtung stark eingeschränkt ist.

JP 04 052 274 A offenbart eine rotierbare zylinderförmige Halterung zum Tragen von Bohrern in einer Beschichtungsanlage. CN 100 529 171 C offenbart eine Beschichtungsanlage mit einer Vorrichtung zum Halten von Bohrern, die aus perforierten ersten, zweiten und dritten Wänden aufgebaut ist.

Es ist die Aufgabe der vorliegenden Erfindung, die oben geschilderten Probleme zumindest teilweise zu lösen.

Diese Aufgabe wird durch die im Anspruch 1 angegebene Erfindung gelöst. Die Halterung wird nicht als hohle Halterung ausgebildet, sondern als Sandwich von zumindest drei beabstandeten Wänden, wobei die Wände derart gekrümmt sind, dass beim Anordnen der Halterung auf dem Drehtisch die Krümmung dem Umfang des Drehtisches im Wesentlichen angepasst ist. Auf diese Weise wird die aus dem Stand der Technik bekannte Polygonform vermieden.

Die Erfindung wird nun beispielhaft und anhand der Figuren im Detail erläutert.
Figur 1a zeigt schematisch den Querschnitt einer einzelnen Halterung gemäss einer ersten Ausführungsform.
Figur 1b zeigt schematisch die Explosionsansicht einer einzelnen Halterung gemäss der ersten Ausführungsform.
Figur 1c zeigt für die erste Ausführungsform die Halterungen, wie sie in einer Beschichtungsanlage anzuordnen wären. Gezeigt ist die Draufsicht auf den Drehtisch.
Figur 2a zeigt schematisch den Querschnitt einer einzelnen Halterung gemäss einer zweiten Ausführungsform
Figur 2b zeigt schematisch die Explosionsansicht einer einzelnen Halterung gemäss der zweiten Ausführungsform.
Figur 2c zeigt den Querschnitt einer einzelnen Halterung gemäss der zweiten Ausführungsform mit variablem Anschlag.
Figur 2d zeigt eine zweite Ausführungsform der Halterungen, wie sie in einer Beschichtungsanlage anzuordnen wären. Gezeigt ist die Draufsicht auf den Drehtisch.
Figur 3a zeigt den Querschnitt einer einzelnen Halterung gemäss einer dritten Ausführungsform.
Figur 3b zeigt die Explosionsansicht der Halterung gemäss der dritten Ausführungsform.

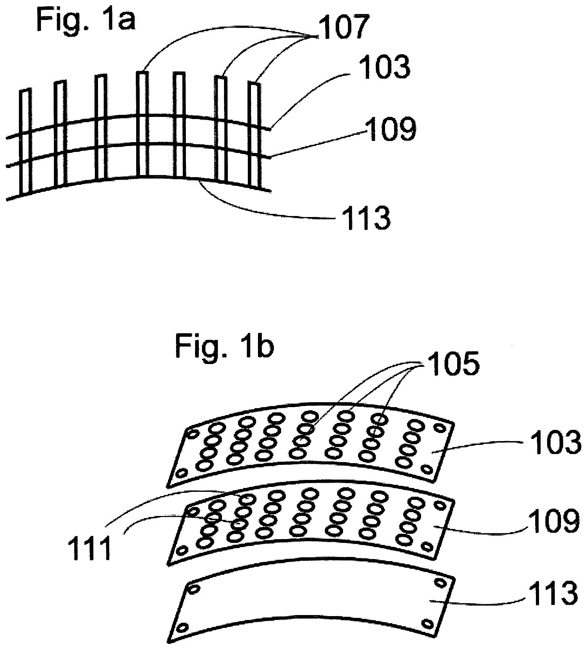

Die Halterung gemäss einer ersten Ausführungsform umfasst eine erste zu einem Kreissegment gekrümmte und perforierte Wand 103 mit einer Anordung von Löchern 105, in die die Bohrer 107 eingeführt werden können. Sie umfasst ausserdem eine zweite gekrümmte und perforierte Wand 109 mit Löchern 111, deren Krümmung im Wesentlichen der Krümmung der ersten Wand 103 entspricht und deren Löchern 111 im Wesentlichen entsprechend den Löchern 105 der ersten Wand 103 angeordnet ist. Die zweite Wand 109 ist beabstandet von der ersten Wand 103 auf deren konkaven Seite angeordnet. Wiederum von der zweiten Wand 109 beabstandet auf deren konkaven Seite angeordnet umfasst die Halterung eine dritte gekrümmte Wand 113, die jedoch keine den Löchern der ersten und zweiten Wand entsprechenden Löcher umfasst. Eine entsprechende Halterung ist schematisch in Figur 1a im Querschnitt und schematisch in Figur 1b in Explosionsdarstellung gezeigt.

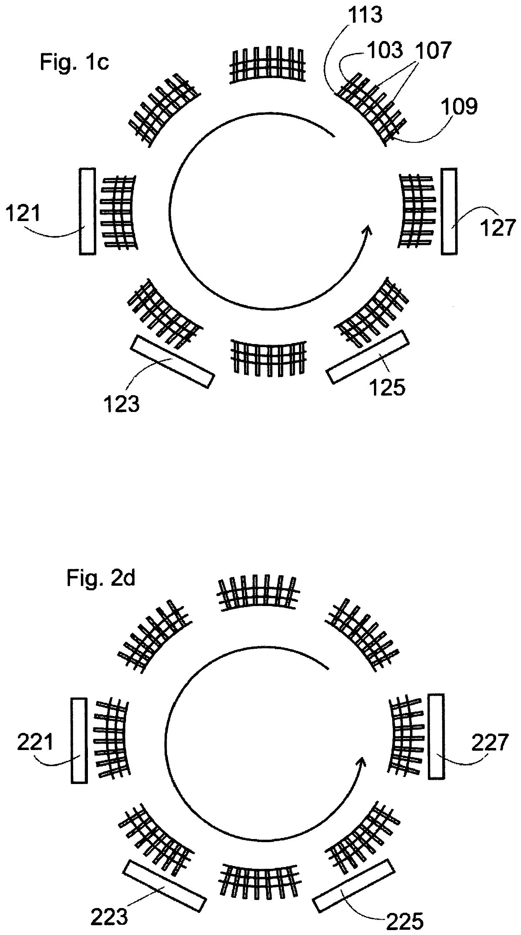

Wie entsprechende Halterungen in der Beschichtungsanlage angeordnet werden ist in Figur 1c gezeigt. Gezeigt sind die ringförmig angeordneten Halterungen die beispielsweise von vier Beschichtungsquellen 121, 123, 125 und 127 umgeben sind, an denen sie verbeirotieren. Dabei wird deutlich, dass die Krümmungen der Halterungen der Grösse der Beschichtungsanlage angepasst sein sollten. Daher liegen die Krümmungsradien der Halterungen zwischen zwischen 0.2m für kleine Beschichtungsanlagen und 3m für grosse Beschichtungsanlagen. Aus der Figur 1c wird auch deutlich, dass jeder der Bohrer mit gleichem minimalen Abstand an der Beschichtungsquelle vorbei rotiert. Es wird ausserdem deutlich, dass mit dieser ersten Ausführungsform das Problem der unsymmetrischen Beschichtung der Spannuten noch nicht gelöst ist.

Dieses Problem wird mit der zweiten Ausführungsform gelöst, die daher eine bevorzugte Ausführungsform ist. Die Halterung gemäss der zweiten Ausführungsform umfasst eine erste zu einem Kreissegment gekrümmte und perforierte Wand 203 mit einer Anordnung von Löchern 205, in die die Bohrer 207 eingeführt werden können. Sie umfasst ausserdem eine zweite zu einem Kreissegment gekrümmte und perforierte Wand 209 mit Löchern 211. Die zweite Wand 209 ist beabstandet von der ersten Wand 203 auf der konkaven Seite angeordnet. Die Halterung umfasst ausserdem eine dritte, zu einem Kreissegment gekrümmte Wand 213. Die dritte Wand 213 ist beabstandet von der zweiten Wand 209 auf der konkaven Seite angeordnet. Sie umfasst keine Löcher welche den Löcher der ersten oder zweiten Wand entsprechen würden. Die Krümmungen der drei Wände sind so gewählt, dass, würden sie zu Kreisen vervollständigt, die Mittelpunkte der Kreise übereinander liegen würden. Die Löcher 211 der zweiten Wand 209 sind so auf die Löcher 205 der ersten Wand 203 abgestimmt, so dass die Bohrer 207 im Wesentlichen radial orientiert sind, wenn sie in die Halterung durch die erste Wand 203 und die zweite Wand 209 gesteckt werden und an der dritten Wand 213 ihren Anschlag finden.

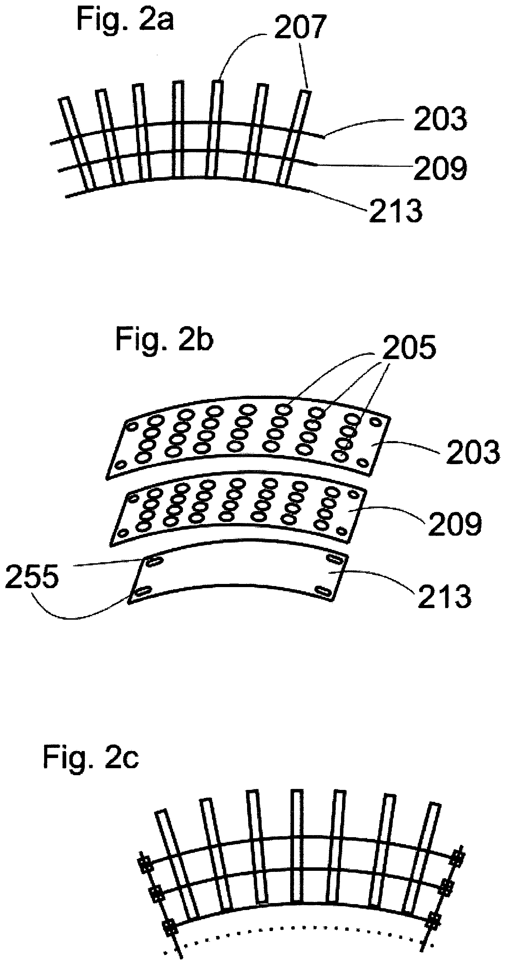

Figur 2c zeigt, wie die drei Wände miteinander durch Streben 251, 253 verbunden werden können. Dabei ist die erste Wand 203 mit der zweiten Wand 209 fix verbunden damit die jeweiligen Löcher für die Bohrer aufeinander abgestimmt bleiben. Demgegenüber kann der Abstand der dritten Wand 213 zur zweiten Wand 209 verändert werden, um von Batch zu Batch unterschiedliche Bohrerlängen beschichten zu können. Dies kann beispielsweise durch Langlöcher 255 ermöglicht werden. In Figur 2c ist eine zweite Position der dritten Wand 213 gestrichelt dargestellt.

Figur 2d zeigt schematisch die Draufsicht einer Beschichtungsanlage in der die Halterungen gemäss der eben beschriebenen zweiten Ausführungsform ringförmig angeordnet sind. Wie man der Figur entnehmen kann ragen sämtliche Bohrer radial nach aussen und werden mit gleichem minimalem Abstand an den Beschichtungsquellen vorbeigeführt.

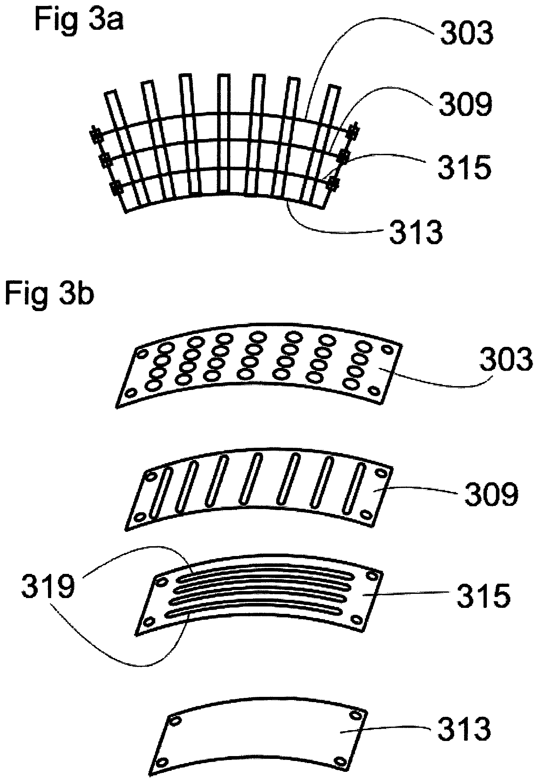

Gemäss einer dritten Ausführungsform wie in die Figuren 3a und 3b dargestellt, umfasst die Halterung vier Wände. Die beiden äusseren Wände 303, 313 entsprechen der ersten Wand und der dritten Wand der beiden ersten Ausführungsformen. Zwischen diesen beiden äusseren Wänden 303, 313 sind noch zusätzlich zwei Wände 309, 315 angeordnet. Die Wand 309, welche in Nachbarschaft zur äusseren Wand 303 angeordnet ist umfasst Schlitze 317, welche senkrecht zur Krümmung der Wand 309 verlaufen. Die Wand 315, welche in Nachbarschaft zur Wand 313 gelegen ist, umfasst Schlitze 319, welche längs der Krümmung der Wand verlaufen. Mit einer solchen Anordnung ist es möglich, durch radiales Verschieben der Wand 309 relativ zur Wand 303 die radiale Orientierung der Bohrer zu justieren. Dies ist zum Beispiel dann von Vorteil, wenn dieselbe Halterung für Beschichtungsanlagen mit unterschiedlichen Kammerdurchmessern eingesetzt werden soll.

Bei den geschilderten Ausführungsformen kommen die Bohrerspitzen, wenn sie in die Halterungen bis zum Anschlag eingesteckt sind, auf einem Zylindermantel zu liegen. Dabei ergibt sich die Möglichkeit, mehrere Zylinder, d.h. mehrere Halterungen übereinander zu stapeln.

Es wurde eine Halterung zum Tragen von Bohrern in einer Beschichtungsanlage offenbart, mit einer perforierten ersten Wand mit ersten Löchern und einer von der ersten Wand beabstandeten zweiten perforierten Wand mit zweiten Löchern oder Schlitzen, die derart auf die ersten Löcher abgestimmt sind, dass Bohrer jeweils in die ersten Löcher und dieselben Bohrer gleichzeitig in die zweiten Löcher oder Schlitzen eingeführt werden können , wobei die Halterung zumindest eine von der zweiten Wand beabstandete dritte Wand umfasst, welche geeignet ist um als Anschlag für in die ersten und zweiten Löcher oder Schlitze eingeführten Bohrer zu dienen und wobei zumindest die erste Wand und die dritte Wand zu Kreissegmenten gebogen sind und daher Krümmungen aufweisen, dergestalt, dass nach dem Einführen der Bohrer bis zum jeweiligen Anschlag, diese als Ensemble dem Kreissegment der dritten Wand folgend mit der Bohrerspitze aus der Halterung herausragen.

Auch die zweite Wand zu einem Kreissegment gekrümmt sein. Die zweite Wand kann beabstandet von der ersten Wand auf deren konkaven Seite angeordnet sein und die dritte Wand kann beabstandet von der zweiten Wand auf der konkaven Seite der ersten Wand angeordnet sein, wobei die zweite Wand zwischen erster und dritter Wand angeordnet ist.

Dabei ist es vorteilhaft, wenn die erste, zweite und dritte Wand relativ zueinander so angeordnet sind und so zu Kreissegmenten gekrümmt sind, dass bei Vervollständigung der Kreise die Mittelpunkte der Kreise im Wesentlichen übereinander liegen.

Es wurde eine Beschichtungsanlage mit Halterungen wie oben beschrieben offenbart, wobei die Halterungen in der Beschichtungsanlage derart angeordnet sind, dass bei der Beschichtung die Bohrer auf eine Kreisbahn mit im Wesentlichen gleichem minimalem Abstand von einer Beschichtungsquelle an dieser vorbeigeführt werden können.

Es wurde ein Verfahren zum Beschichten einer Reihe von Bohrern offenbart, bei dem die Bohrer zu Beschichtung in zumindest eine auf einer Kreisbahn rotierenden Halterung mit einer perforierten ersten Wand mit ersten Löchern und einer perforierten zweiten Wand mit zweiten Löchern oder Schlitzen eingesteckt werden, dadurch gekennzeichnet, dass die aus der Halterung herausragenden Spitzen der Bohrer im Wesentlichen auf einem Zylindermantel liegen, wobei die Achsen der Bohrer nicht zur Rotationsachse der zumindest einen Halterung parallel sind und vorzugsweise senkrecht auf dem Zylindermantel stehen.

## Patentansprüche

1. Halterung zum Tragen von Bohrern in einer Beschichtungsanlage, mit einer perforierten ersten Wand mit ersten Löchern und einer von der ersten Wand beabstandeten zweiten perforierten Wand mit zweiten Löchern oder Schlitzen, die derart auf die ersten Löcher abgestimmt sind, dass Bohrer jeweils in die ersten Löcher und dieselben Bohrer gleichzeitig in die zweiten Löcher oder Schlitzen eingeführt werden können, wobei die Halterung zumindest eine von der zweiten Wand beabstandete dritte Wand umfasst, welche geeignet ist um als Anschlag für in die ersten und zweiten Löcher oder Schlitze eingeführten Bohrer zu dienen, ***dadurch gekennzeichnet, dass*** zumindest die erste Wand und die dritte Wand zu Kreissegmenten gebogen sind und daher Krümmungen aufweisen, wobei die Krümmungen der Wände so gewählt sind, dass, würden die Wände zu Kreisen vervollständigt, die Mittelpunkte der Kreise im Wesentlichen übereinander liegen würden, dergestalt, dass, wenn die in die ersten und zweiten Löcher eingeführten Bohrer bis zum jeweiligen Anschlag eingeführt sind, diese als Ensemble dem Kreissegment der dritten Wand folgend mit der Bohrerspitze aus der Halterung herausragen.

2. Halterung nach Anspruch 1, ***dadurch gekennzeichnet, dass*** auch die zweite Wand
zu einem Kreissegment gekrümmt ist.

3. Halterung nach Anspruch 2, ***dadurch gekennzeichnet, dass*** die zweite Wand beabstandet von der ersten Wand auf deren konkaven Seite angeordnet ist und die dritte Wand beabstandet von der zweiten Wand auf der konkaven Seite der ersten Wand angeordnet ist wobei die zweite Wand zwischen der ersten und der dritten Wand angeordnet ist, wobei die erste, zweite und dritte Wand relativ zueinander so angeordnet sind und so zu Kreissegmenten gekrümmt sind, dass bei einer Vervollständigung der Wände zu Kreisen, die Mittelpunkte der Kreise im Wesentlichen übereinander liegen würden.

4. Beschichtungsanlage mit Halterungen nach einem der vorangehenden Ansprüche, ***dadurch gekennzeichnet, dass*** die Halterungen in der Beschichtungsanlage derart angeordnet sind, dass bei der Beschichtung die Bohrer auf eine Kreisbahn mit im Wesentlichen gleichem minimalem Abstand von einer Beschichtungsquelle an dieser vorbeigeführt werden können.

5. Verfahren zum Beschichten einer Reihe von Bohrern, bei dem die Bohrer zu Beschichtung in zumindest eine auf einer Kreisbahn rotierenden Halterung mit einer perforierten ersten Wand mit ersten Löchern und einer perforierten zweiten Wand mit zweiten Lochern oder Schlitzen eingesteckt werden, ***dadurch gekennzeichnet, dass*** das Beschichtungsverfahren in einer Beschichtungsanlage nach Anspruch 4 durchgeführt wird, wobei die aus der Halterung herausragenden Spitzen der Bohrer im Wesentlichen auf einem Zylindermantel liegen, wobei die Achsen der Bohrer nicht zur Rotationsachse der zumindest einen Halterung parallel sind und vorzugsweise senkrecht auf dem Zylindermantel stehen.

## Claims

1. Holder for carrying borers in a coating facility, having a first wall perforated with first holes and a second wall at a distance from the first wall and perforated with second holes or slits that are adjusted to the first holes in such a manner that borers can be inserted each into the first holes and the same borers simultaneously into the second holes or slits, wherein the holder comprises at least a third wall at a distance from the second wall and which is suitable for serving as a stop for the borers inserted into the first and second holes or slits, **characterized in that** at least the first wall and the third wall are curved to segments of circle and thus have curves, wherein the curves of the walls are chosen in such a manner that, if the walls were completed to circles, the centers of the circles would essentially lie superimposed above one another in such a manner that, when the borers inserted into the first and second holes are inserted up to the respective stop, these protrude as a whole with the borer tip from the holder, following the segment of circle of the third wall.

2. Holder according to claim 1, **characterized in that** also the second wall is curved to a segment of circle.

3. Holder according to claim 2, **characterized in that** the second wall is arranged at a distance from the first wall on its concave side and the third wall is arranged at a distance from the second wall on the concave side of the first wall, wherein the second wall is arranged between the first and third walls, wherein the first, second and third walls are arranged relative to one another and curved to segments of circle in such a manner that, if the walls were completed to circles, the centers of the circles would essentially lie superimposed above one another.

4. Coating facility with holders according to one of the preceding claims, **characterized in that** the holders are arranged in the coating facility in such a manner that during coating the borers can be presented to a coating source in a circular path with essentially the same minimum distance from the coating source.

5. Method for coating a series of borers, where the borers for coating are inserted in at least one holder rotating in a circular path and having a first wall perforated with first holes and a second wall perforated with second holes or slits, **characterized in that** the coating method is carried out in a coating facility according to claim 4, wherein the tips of the borers protruding from the holder essentially rest on a cylindrical surface, wherein the axes of the borers are not parallel to the rotation axis of the at least one holder and are preferably perpendicular to the cylindrical surface.

## Revendications

1. Support destiné à porter des forets dans une installation de revêtement ayant une première paroi perforée de premiers trous et une seconde paroi étant à distance de la première paroi et perforée de seconds trous ou fentes qui sont adaptés aux premiers trous de telle manière que des forets peuvent être introduits dans les premiers trous et les mêmes forets peuvent être introduits simultanément dans les seconds trous ou fentes, ledit support comprenant du moins une troisième paroi qui est à distance de la seconde paroi et qui est appropriée à servir de butée pour les forets introduits dans les premiers et seconds trous ou fentes, **caracterisé par le fait que** du moins la première paroi et la troisième paroi sont courbées sous forme de segments de cercle et, par consquéquent, présentent des courbures, lesdites courbures des parois étant choisies de telle manière que, si les parois étaient completées en cercles, les centres des cercles se superposaient essentiellement l'un sur l'autre de telle manière que, lorsque les forets introduits dans les premiers et seconds trous sont introduits jusqu'à la butée respective, ceux-ci en tant qu'un ensemble débordent avec la pointe de foret du support tout en suivant le segment de cercle de la troisième paroi.

2. Support selon la revendication 1, **caractérisé par le fait que** la deuxième paroi est également courbée sous forme d'un segment de cercle.

3. Support selon la revendication 2, **caracterisé par le fait que** la deuxième paroi est disposée à distance de la première paroi sur son côté concave et la troisième paroi est disposée à distance de la seconde paroi sur le côté concave de la première paroi, la seconde paroi étant disposée entre la première paroi et la troisième paroi, la première, la seconde et la troisième paroi étant disposées relativement l'une par rapport à l'autre et étant courbées sous forme de segments de cercle de telle manière que, si les parois étaient complétées en cercles, les centres des cercles se superposaient essentiellement l'un sur l'autre.

4. Installation de revêtement comprenant des supports selon une des revendications précédentes, **caractérisée par le fait que** les supports sont disposés dans l'installation de revêtement de telle manière que pendant le revêtement les forets peuvent être présentés sur un trajet circulaire à une source de revêtement essentiellement à la même distance minimale de cette source de revêtement.

5. Procédé de revêtement d'une série de forets où les forets sont introduits pour le revêtement dans du moins un support tournant sur un trajet circulaire, ledit support ayant une première paroi perforée de premiers trous et une seconde paroi perforée de seconds trous ou fentes, **caractérisé par le fait que** le procédé de revêtement est executé dans une installation de revêtement selon la revendication 4, les pointes des forets débordant du support étant situées essentiellement sur une surface cylindrique, les axes des forets n'étant pas parallèles à l'axe de rotation du du moins un support et de préférence sont perpendiculaires à la surface cylindrique.
